# EUROPEAN PATENT APPLICATION

(11) **EP 2 398 045 A2**
(43) Date of publication of application: **21.12.2011**
(21) Application number: 11169723.1
(22) Date of filing: 14.06.2011
(51) Int. Cl.: H01L 21/36, H01L 21/02

(54) **Modified cadmium telluride layer, a method of modifying a cadmium telluride layer, and a thin film device having a cadmium telluride layer**

(30) Priority: 18.06.2010 US 818669
(71) Applicant: PrimeStar Solar, Inc, Arvada, CO 80004 (US)
(72) Inventor: Frey, Jonathan M., Arvada, CO Colorado 80004 (US)
(74) Representative: Szary, Anne Catherine

(57) **Abstract**

A layer (209) including modified cadmium telluride and unmodified cadmium telluride disposed within the cadmium telluride layer. The modified area (513) includes a concentration of telluride that is greater than the concentration of telluride in the unmodified cadmium telluride area. The modified area (513) also includes a hexagonal close packed crystal structure. A method for modifying a cadmium telluride layer and a thin film device are also disclosed.

## Description

### FIELD OF THE INVENTION

The present disclosure is directed to thin films and devices and methods for modifying thin films and thin film devices. More particularly, the present disclosure is directed to thin films containing cadmium telluride and films and a method for modifying cadmium telluride layers.

### BACKGROUND OF THE INVENTION

Energy demand is constantly increasing. As the energy demand increases, sources alternative to fossil fuel energy sources increase in importance. One such alternative energy source is solar energy. Generally, solar energy is produced by converting radiation (for example, sunlight) into electricity which may be stored or transmitted through electrical power grids.

Generally, thin film cadmium telluride (CdTe) photovoltaic cells include a CdTe/CdS junction, which generates electricity when the junction is exposed to light. However, CdTe thin films have a high contact resistance. Additional process steps, such as Cudoping and/or annealing, are utilized to form desired electrical contacts. For example, one known method for improving electrical contact is to chemically etch the surface with a nitric and phosphoric acid, followed by a copper doping step. This known method forms a tellurium rich surface that has reduced contact resistance. However, these additional process steps require significant energy and additional materials to provide the desired contacts for use in photovoltaic modules.

What is needed is improved contact resistance and electrical contacts in cadmium telluride thin film layers. In addition, processes and systems are needed that do not require additional steps and materials needed for known processes for forming electrical contacts.

### SUMMARY OF THE INVENTION

One embodiment includes A layer including modified cadmium telluride and unmodified cadmium telluride disposed within the cadmium telluride layer. The modified area includes a concentration of telluride that is greater than the concentration of telluride in the unmodified cadmium telluride area. The modified area also includes a hexagonal close packed crystal structure.

Another aspect of the disclosure includes a method of modifying a layer comprising cadmium telluride. The method includes providing the layer comprising cadmium telluride and directing concentrated electromagnetic energy to at least a portion of the layer to selectively remove cadmium from the cadmium telluride layer to form a modified area having a concentration of telluride that is greater than the concentration of telluride in an unmodified cadmium telluride area. In addition, the method includes modifying the layer to produce a hexagonal close packed crystal structure.

Another aspect of the disclosure includes a thin film device having a cadmium telluride layer. The device includes a modified area and an unmodified cadmium telluride area disposed within the cadmium telluride layer, the modified area having a concentration of telluride that is greater than the concentration of telluride in the unmodified cadmium telluride area, the modified area comprising a hexagonal close packed crystal structure and the layer being disposed within the device.

### BRIEF DESCRIPTION OF THE DRAWINGS

FIG. 1 shows a thin film module mounted on a base according to the disclosure.
FIG. 2 is a diagram of a layer system making up cells of a module according to the disclosure.
FIG. 3 is a process flow diagram for an exemplary process for forming a module according to the disclosure.
FIG. 4 is a process flow diagram for an exemplary process according to the disclosure.
FIG. 5 shows an apparatus for performing the method according to the disclosure.
FIG. 6 shows an exemplary method for performing the method according to the disclosure.
FIG. 7 shows another exemplary method for performing the method according to the disclosure.
FIG. 8 shows an X-ray diffraction pattern for a laser modified cadmium telluride layer.
FIGs. 9-13 show photomicrographs of modified cadmium telluride according to the disclosure.
FIG. 14 shows a plot of current density voltage plot for isolated PV test cells.

Wherever possible, the same reference numbers will be used throughout the drawings to represent the same parts.

### DETAILED DESCRIPTION OF THE INVENTION

Provided is a cadmium telluride thin film having improved contact resistance and electrical contacts formed without the additional steps and materials needed for known processes for forming electrical contacts.

One advantage of the present disclosure includes a reduction in contact resistance in comparison with the same material without treatment. Another advantage of the present disclosure includes applying the method disclosed to commercial processing and replacing one or more steps of known processes used for making an electrical contact to a CdTe thin film. Another advantage of the present disclosure includes applying the method while varying the composition of the ambient environment so as to include glasses, liquids, or powders containing doping compounds. An example of such processing variations includes laser surface treatment of CdTe thin films in presence of Cu-, Cl-, N-, As-, Sb-, Ag-, Au-, or P- containing compounds. Another advantage of the present disclosure includes converting the crystal structure to a hexagonal close packed lattice crystal structure.

The present disclosure describes a method of inducing a material or chemical change or modification in cadmium telluride thin film structures or layers to form a modified area using concentrated electromagnetic energy. "Modified area," as used herein, includes a portion or section of the cadmium telluride that has a material change in composition and/or structure. The modified area may include a surface, an interior portion, an edge or any combination of the film or layer. In addition, the modified area may include some or all of the cadmium telluride layer.

"Contact resistance," as used herein, is the resistance to electrical current flow introduced by a poor quality ohmic contact to a substrate or layer, such as CdTe. In PV cells, contact resistance is a resistive loss of the power generated within the cell. Higher contact resistance linearly equates to higher power loss.

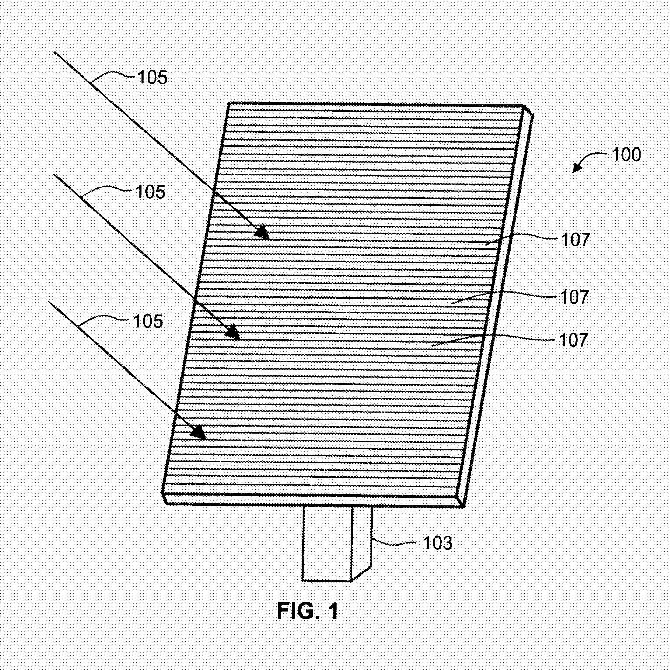

FIG. 1 shows a thin film PV module 100 mounted on a base 103. The PV module is arranged to receive light 105. The PV module is divided into a plurality of cells 107 that are arranged in series. The cells 107 are divided by spaces, non-conductive material and/or other structures separating circuits. For example, cells 107 may be isolated from each other by scribes formed by laser scribing. When the PV module 100 is exposed to light 105, electricity is produced. The disclosure is not limited to the arrangement shown and may include other mounting arrangements and/or cells 107. For example, the cells 107 may be oriented along the long dimension of module 100 instead of the short dimension of module 100. One embodiment of the disclosure includes a thin film CdTe solar photovoltaic (PV) module. Such modules are used to produce solar electricity for numerous applications, for example, large ground-mounted systems and rooftop systems on commercial and residential buildings.

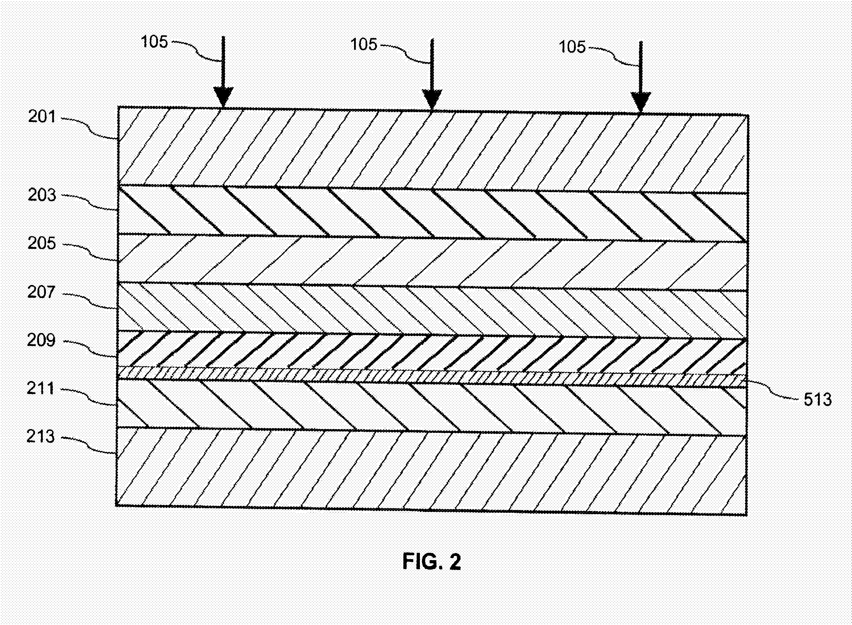

FIG. 2 is a diagram of the layer system making up cells 107 of PV module 100. The layers of cell 107 include a superstrate 201, a first conductive layer 203, a buffer layer 205, a first semiconductor layer 207, a second semiconductor layer 209, a second conductive layer 211 and an encapsulating glass 213. The layers of the cell 107 are arranged to generate and conduct electricity in a usable form when exposed to light 105.

The superstrate 201 is a sheet of high transmission glass onto which thin films are grown. The superstrate 201 receives the light 105 (see e.g., FIG. 1) prior to the underlying layers. Superstrate 201 may be a high-transmission, low-iron float glass or any other suitable glass material having a high transmission rate for light 105. In another embodiment, the superstrate 201 may also be a high transmission borosilicate glass.

After the light 105 passes through superstrate 201, at least a portion of the light 105 passes through first conductive layer 203. First conductive layer 203 may be a transparent conductive oxide (TCO), which permits transmission of light 105 with little or no absorption. The first conductive layer 203 is also electrically conductive, which permits electrical conduction to provide the series arrangement of cells 107. In one embodiment, the first conductive layer 203 is about 0.15-0.3 µm of stoichiometric cadmium stannate (nominally Cd₂SnO₄).

Other suitable first conductive layers 203 may include fluorine-doped tin oxide, aluminum-doped zinc oxide, indium tin oxide, doped indium oxide, zinc or cadmium doped tin oxide, copper aluminum oxides or another compound of cadmium tin oxide (such as CdSnO₃). First conductive layer 203 may permit passage of light 105 through to the semiconductor layers (e.g., first semiconductor layer 207 and second semiconductor layer 209) while also functioning as an ohmic electrode to transport photogenerated charge carriers away from the light absorbing material.

A buffer layer 205 is adjacent to first conductive layer 203. Buffer layer 205 is more electrically resistive and protects the layers of cell 107 from chemical interactions from the glass and/or interactions which might be incurred from subsequent processing. Inclusion of buffer layer 205 reduces or prevents electrical or other losses that may take place across cell 107 and across module 100. Suitable materials for buffer layer 205 may include tin oxide containing materials, such as zinc doped tin oxide, a mixture of zinc and tin oxides (for example, zinc tin oxide having 0.5 to 33 atomic % Zn), zinc stannate, gallium oxide, aluminum oxide, silicon oxide, indium oxide, cadmium oxide and any other suitable barrier material having more electrical resistivity than first conductive layer 203 and the capability of protecting the layers of the cell 107 from interactions from the glass or interactions from subsequent processing. In addition, the inclusion of buffer layer 205 permits the formation of a first semiconductor layer 207 which permits photon passage while maintaining a high quality junction capable of generating electricity. In certain embodiments, buffer layer 205 may be omitted or substituted by another material or layer. In one embodiment, buffer layer 205 includes a combination of ZnO and SnO₂. For example, the buffer layer 205 may be formed to a thickness of up to about 1.5 microns or about 0.8-1.5 microns and may include ZnO and SnO₂ in about a one to two (1:2) stoichiometric ratio.

As shown in FIG. 2, first semiconductor layer 207 is adjacent to buffer layer 205 and receives light 105 subsequent to superstrate 201, first conductive layer 203 and buffer layer 205. First semiconductor layer 207 includes a wide bandgap n-type semiconductor material. Suitable semiconductor material for first semiconductor layer 207 includes, but is not limited to, CdS, SnO₂, CdO, ZnO, AnSe, GaN, In₂O₂, CdSnO, ZnS, CdZnS or other suitable n-type semiconductor material. In one embodiment, the first semiconductor layer 207 includes CdS. First semiconductor layer 207 may a have thickness from about 0.01 to about 0.1 µm. First semiconductor layer 207 may be formed by chemical bath deposition or by sputtering. First semiconductor layer 207 preferably has a smooth surface and is substantially uniform and free of impurities and pinholes.

First semiconductor layer 207 forms the junction with second semiconductor layer 209 to create the photovoltaic effect in cell 107, allowing electricity to be generated from light 105. Second semiconductor layer 209 may include Cd, CdTe or other p-type semiconductor material. When second semiconductor layer 209 is provided with first semiconductor layer 207, a photovoltaic effect results when exposed to light 105.

As shown in FIG. 2, second semiconductor layer 209 is adjacent to first semiconductor layer 207. A second conductive layer 211 is adjacent to the second semiconductor layer 209 and provides an electrically conductive material that is capable of conducting electricity formed from the combination of the first semiconductor layer 207 and second semiconductor layer 209 when exposed to light 105. Although FIG. 2 shows an arrangement of two layers for first semiconductor layer 207 and second semiconductor layer 209, any number of layers, including interfacial layers, may be utilized to provide the photovoltaic effect.

Second conductive layer 211 may be fabricated from any suitable conductive material and combinations thereof. For example, suitable materials include materials including, but not limited to, graphite, metallic silver, nickel, copper, aluminum, titanium, palladium, chrome, molybdenum alloys of metallic silver, nickel, copper, aluminum, titanium, palladium, chrome, and molybdenum and any combination thereof. In one embodiment, second conductive layer 209 may be a combination of graphite, nickel and aluminum alloys.

An encapsulating glass 213 may be adhered adjacent to second conductive layer 211. Encapsulating glass 213 may be a rigid structure suitable for use with the thin films of cell 107. Encapsulating glass 213 may be the same material as superstrate 201 or may be different. In addition, although not shown in FIG. 2, encapsulating glass 213 may include openings or structures to permit wiring and/or connection to cell 107.

Module 100 and individual cells 107 may include other layers and structures not shown in FIG. 2. For example, superstrate 201 and/or encapsulating glass 213 may include a barrier coating or other structure in order to reduce or prevent diffusion of impurities into the layers. In addition, encapsulating glass 213 may include an adherent layer to adhere encapsulating glass 213 to the layers. Additional structures that may be present in module 100 and/or cells 107 include scribes, bussing structures, external wiring, and various conventional components useful with thin film and/or PV structures.

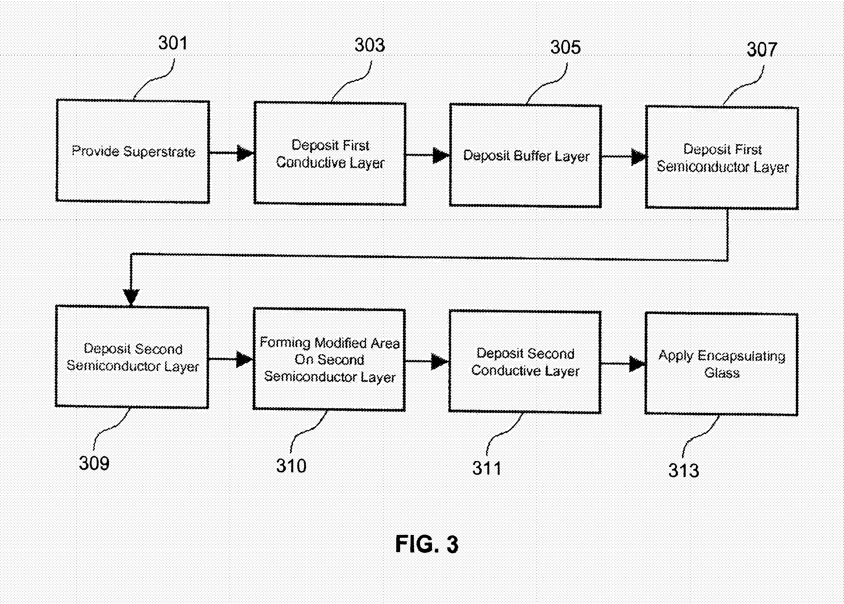

FIG. 3 shows a process flow diagram for an exemplary process for forming module 100. The process includes the formation of a thin film stack forming cell 107, wherein the films or layers are formed on superstrate 201 (shown from the top down in FIG. 2).

As shown in the flow diagram of FIG. 3, superstrate 201 is provided (box 301). Superstrate 201 may be fabricated from any suitable material capable of receiving thin films for use as photovoltaic cells and sufficiently transparent to allow transmission of light 105.

Subsequent to providing superstrate 201, first conductive layer 203 is deposited onto superstrate 201 (box 303). First conductive layer 203 is electrically conductive, which permits electrical conduction to provide the series arrangement of cells 107. In one embodiment, first conductive layer 203 is about 0.15-0.3 µm of stoichiometric cadmium stannate (nominally Cd₂SnO₄). Other suitable first conductive layers 203 may include fluorine-doped tin oxide, aluminum-doped zinc oxide, indium tin oxide, doped indium oxide, zinc or cadmium doped tin oxide, copper aluminum oxides or another compound of cadmium tin oxide (such as CdSnO₃). First conductive layer 203 can be formed, for example, by direct current (DC) or radio frequency (RF) sputtering. In one embodiment, first conductive layer 203 is a layer of substantially amorphous Cd₂SnO₄ that is sputtered onto superstrate 201. Such sputtering can be performed from a hot-pressed target containing stoichiometric amounts of SnO₂ and CdO onto superstrate 201 in a ratio of 1 to 2. The cadmium stannate can alternately be prepared using cadmium acetate and tin (II) chloride precursors by spray pyrolysis.

Once first conductive layer 203 is deposited, buffer layer 205 may be deposited to first conductive layer 203 (box 305). In one embodiment, buffer layer 205 may be formed, for example, by sputtering. In one example, buffer layer 205 may be formed by sputtering from a hot-pressed target containing, for example, primarily Sn and 1-22% Zn by weight or stoichiometric amounts of about 67 mol % SnO₂ and about 33 mol % ZnO onto first conductive layer 203. When deposited by sputtering, the zinc tin oxide material for buffer layer 205 may be substantially amorphous. Buffer layer 205 may have a thickness of between about 200 and 3,000 Angstroms, or between about 800 and 1,500 Angstroms, in order to have desirable mechanical, optical, and electrical properties. Buffer layer 205 may have a wide optical bandgap, for example about 3.3 eV or more, in order to permit the transmission of light 105.

First semiconductor layer 207 is deposited on buffer layer 205 (box 307). In one embodiment, first semiconductor layer 207 may be formed, for example, by chemical bath deposition or sputtering. First semiconductor layer 207 may be deposited to the thickness of from about 0.01 to 0.1 µm. One suitable material for use as first semiconductor layer 207 is CdS. A suitable thickness for a CdS layer may range from about 500 to 1000 Angstroms. First semiconductor layer 207 forms the junction with second semiconductor layer 209 to create the photovoltaic effect in cell 107, allowing it to generate electricity from light 105.

After the formation of first semiconductor layer 207, second semiconductor layer 209 is deposited on first semiconductor layer 207 (box 309). Second semiconductor layer 209 may include Cd, CdTe or other p-type semiconductor material. Second semiconductor layer 209 may be deposited by diffusive transport deposit, sputtering or other suitable deposition method for depositing p-type semiconductor thin film material.

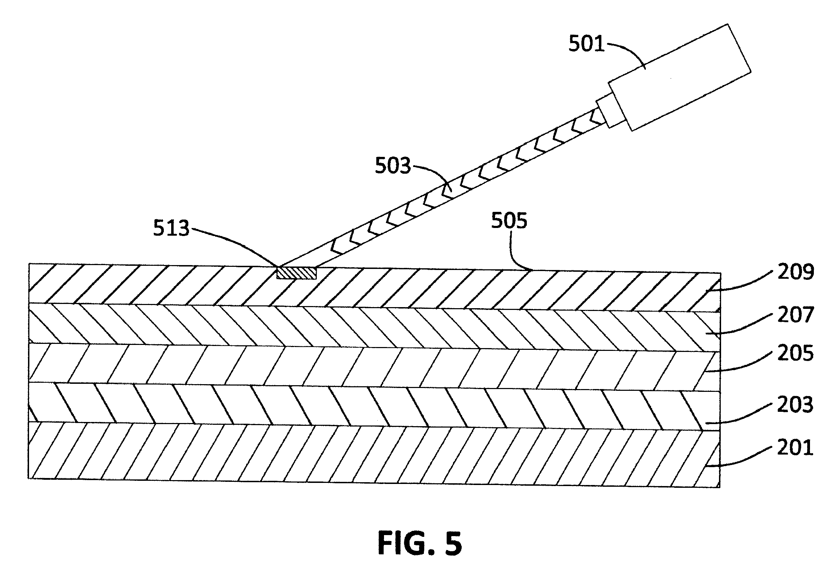

A modified area 513(see FIG. 2) is formed on or within the second semiconductor layer 209 (box 310). The modified area 513 is an area in which the material of the second semiconductor layer 209 is at least partially crystallized. The modified area 513 may be located along the second semiconductor layer 209 or may include the entire surface or entire bulk of second semiconductor layer 209. In one embodiment, the second semiconductor layer 209 is a cadmium telluride film layer and the modified area 513 includes a composition that has a greater concentration of tellurium than the unmodified cadmium telluride film layer. The unmodified cadmium telluride film layer includes a layer formed as cadmium telluride is otherwise provided substantially without exposure to concentrated electromagnetic energy 503 (see for example FIG. 5). In addition, the unmodified cadmium telluride film layer includes a cubic crystal structure and the composition of the modified area 513 includes a hexagonal close packed structure.

Subsequent to the formation of the second semiconductor layer 209 and modification of the second semiconductor layer 209 to form the modified area 513, second conductive layer 211 is deposited (box 311). The second conductive layer 211 is applied to the second semiconductor layer 209 and may be in contact with the modified area 513. Second conductive layer 211 may be fabricated from any suitable conductive material. Second conductive layer 211 may be formed by sputtering, electrodeposition, screen printing, physical vapor deposition (PVD), chemical vapor deposition (CVD) or spraying. In one embodiment, second conductive layer 209 is a combination of graphite that is screen printed onto the surface and nickel and aluminum alloy that is sputtered thereon.

All the sputtering steps described above may be magnetron sputtering at ambient temperature under highly pure atmospheres. However, other deposition processes may be used, including higher temperature sputtering, electrodeposition, screen printing, physical vapor deposition (PVD), chemical vapor deposition (CVD) or spraying. In addition, the processing may be provided in a continuous line or may be a series of batch operations. When the process is a continuous process, the sputtering or deposition chambers are individually isolated and brought to coating conditions during each coating cycle and then repeated.

Once second conductive layer 21 is formed, encapsulating glass 213 is applied to second conductive layer 211 (box 313). In one embodiment, the encapsulating glass 213 is adhered to the second conductive layer 211 with adhesive or other suitable compound for adhering. Encapsulating glass 213 may be a rigid material suitable for use with thin film structures and may be the same material or different material than superstrate 201. Encapsulating glass 213 may be adhered to second conductive layer 211 using any suitable method. For example, encapsulating glass 213 may be adhered to second conductive layer 211 using an adhesive or other bonding composition.

Although not shown in FIG. 3, other processing steps may be included in the process for forming module 100 and cells 107. For example, cleaning, etching, doping, dielectric or other selective insulative material deposition, formation of interstitial layers, scribing, heat treatments, and wiring may also be utilized. For example, wiring and/or bussing devices may be provided to complete the PV circuit (i.e., cells 107 in series arrangement) and to provide connectivity of the PV circuit to a load or other external device.

Scribing may be utilized to form the interconnections between the layers and isolate cells and/or layers of the thin film stack. Scribing may be accomplished using any known technique for scribing and/or interconnecting the thin film layers. In one embodiment, scribing is accomplished using a laser directed at one or more layers from one or more directions. One or more laser scribes may be utilized to selectively remove thin film layers and to provide interconnectivity and/or isolation of cells 107. In one embodiment, the scribes and layer deposition are accomplished to interconnect and/or isolate cells 107 to provide a PV circuit having cells 107 in a series of electrical arrangements.

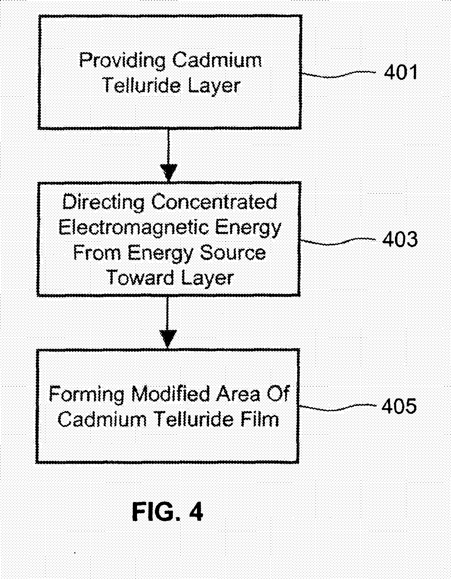

FIG. 4 includes a flowchart illustrating an exemplary method for forming modified area 513. The method includes providing a cadmium telluride layer (box 401). The cadmium telluride may, for example, be a second semiconductor layer 209 for a photovoltaic module (see FIG. 2). In other embodiments, the cadmium telluride may be a layer within a thin film device, such as a gamma detector.

The cadmium telluride layer includes cadmium telluride, cadmium and telluride containing compounds, and/or alloys of cadmium telluride. The cadmium telluride layer is defined as any layer that contains cadmium telluride, cadmium and tellurium containing compounds and/or alloys of cadmium telluride. In addition, the cadmium telluride layer may include additives, such as, for example, Cu, Cl, N, As, Sb, Ag, Au, or P; or Cu-, Cl-, N-, As-, Sb-, Ag-, Au-, or P- containing compounds. The method further includes directing a concentrated electromagnetic energy 503 from an energy source 501 (see, for example, FIG. 5) toward the cadmium telluride layer (box 403). Suitable energy sources may include, but are not limited to, laser, radio frequency (Rf), electron beam, infrared (IR) or source for rapid thermal process/anneal (RTA). The laser or other energy source is configured to generate concentrated electromagnetic energy or beam with a power density and/or wavelength that provides heat and/or other suitable energy to the cadmium telluride film. The term "concentrated electromagnetic energy" includes directed energy in any suitable form and may include, but is not limited to, laser beams, directed Rf energy, electron beams, directed IR energy or any other directed or concentrated energy capable of providing energy to a surface. The heat and/or other suitable energy may be sufficient to provide modification of the layer upon cooling. By "modification," modifying or grammatical variations thereof, it is meant that the surface or area of the layer is altered physically and/or chemically, resulting in a change in composition and/or structure, such as crystal structure. In one embodiment, a laser emitting a beam having a wavelength of 100-1500 nm and a fluence of from about 0.01 J/cm² to about 100 J/cm² or about 0.1 J/cm² serves as the energy source 501.

As shown in FIG. 4, the method further includes modifying the cadmium telluride layer to form a modified area 513 (box 405). The modified area 513 includes a concentration of telluride that is greater than the concentration of telluride in the remaining portions of the cadmium telluride layer or the unmodified cadmium telluride layer. While not wishing to be bound by theory, the alteration in concentration of telluride may result from the increased rate of vaporization of cadmium over that of tellurium when exposed to the energy of concentrated electromagnetic energy 503 (see FIG. 5). The increase in the concentration of tellurium decreases the contact resistance at the surface of the modified area 513. In addition, the modified area includes a modified crystal structure, wherein the crystal structure of the modified area is different than the crystal structure of the cadmium telluride layer. In one embodiment, the crystal structure of the modified area 513 is a hexagonal close packed structure. While not wishing to be bound by theory, it is believed that the alteration of the composition in combination with the energy present by exposure to concentrated electromagnetic energy 503 results in the alteration of the crystal structure.

FIG. 5 illustrates an apparatus for forming the modified area 513 on a thin film stack for use in a photovoltaic module. As shown in FIG. 5, an energy source 501 emits concentrated electromagnetic energy 503 that is directed at surface 505 of second semiconductor layer 209. The second semiconductor layer 209 may be cadmium telluride. The energy source 501 is an energy source capable of providing sufficient heat and/or other suitable energy to the surface of the second semiconductor layer 209 to modify the second semiconductor layer 209. For example, the energy source may be configured to provide sufficient heat and/or energy to the surface 505 to modify a cadmium telluride layer in such a manner to increase the concentration of tellurium in the layer and alter the crystal structure of the cadmium telluride layer. The increase in the concentration of tellurium is sufficient to decrease the contact resistance of the modified area 513. In one embodiment, the energy source is a laser that emits a beam 503 having a wavelength of from about 100-1500 nm. Suitable wavelengths include 260 nm, 350 nm, 532 nm and 1064 nm. Pulse durations of the laser range from 1 ns to 500 ns. In addition, the laser may include a beam 503 having fluence of from about 0.01 J/cm² to about 1 J/cm² or about 0.1 J/cm². When concentrated electromagnetic energy 503 contacts the surface 505, the second semiconductor layer 209 is locally heated at the location at which the concentrated electromagnetic energy 503 contacts the surface 505. The heat is sufficient to alter the composition of the second semiconductor layer 209 and alter the crystal structure of the second semiconductor layer 209. The atmosphere in which the cadmium stannate is treated may be ambient gas compositions such as air, CO, N₂:H₂ (forming gas), O₂, and combinations thereof. While the above has been described as contacting surface 505, the concentrated electromagnetic energy 503 may be configured in a manner to heat a portion within the second semiconductor layer 209.

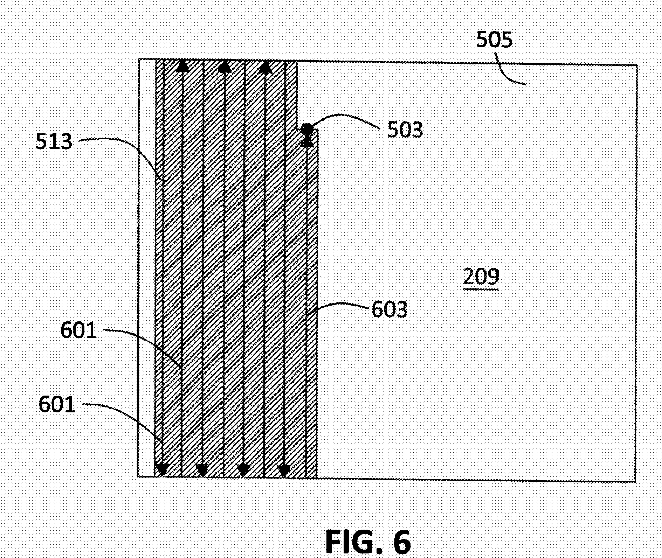

FIG. 6 shows a top view of a second semiconductor layer 209 comprising cadmium telluride, being subjected to the method of the present disclosure. As shown, a concentrated electromagnetic energy 503 is traced along path 601 locally heating the surface 505 of second semiconductor layer 209. After the concentrated electromagnetic energy 503 heats the surface, the second semiconductor layer 209 is modified to form modified area 513. The embodiment shown in FIG. 6 includes a path 601 that traces back and forth across the surface 505 in a direction 603. However, the path 601 of concentrated electromagnetic energy 503 is not so limited and may include any suitable path 601 for concentrated electromagnetic energy 503.

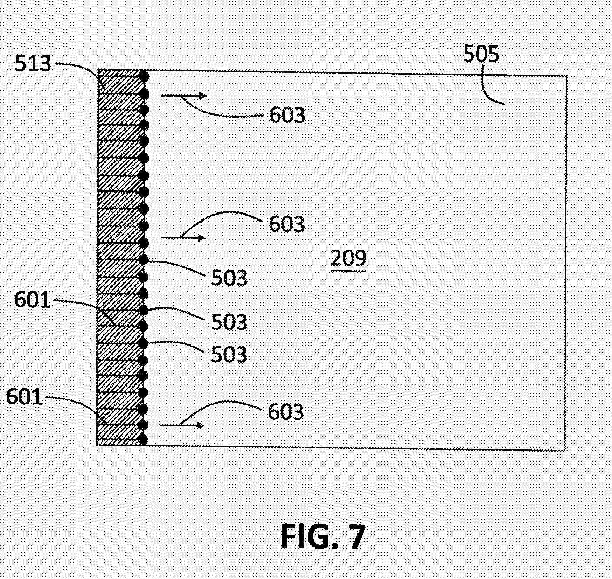

FIG. 7 shows an alternate arrangement, wherein a plurality of beams 503 are utilized to simultaneously modify the surface 505 of the second semiconductor layer 209. In this embodiment, the beams 503 may provide the treatment in a single pass in direction 603, which reduces the process time required. Similar to the embodiment of FIG. 6, the second semiconductor layer 209 is crystallized to form modified area 513 along path 601 of beams 503.

### EXAMPLES

Photovoltaic devices were formed using the following thin film stack: SnO₂ / ZTO / CdS / CdTe / NiV / Al / NiV. In Example 1, the CdTe layer includes a laser treatment and in the Comparative Example, the CdTe was not modified and remained unmodified.

Example 1 - CdTe layer with exposure to laser beam: The laser treatment of the CdTe layer of the Example utilized the following conditions:
1^{st} Pass at 0 Degree Angle,
Fluence: 0.3 J/cm²,
Pulse Duration: ~150ns,
Pulse Repetition Frequency: 80 kHz,
Wavelength: 1070nm,
Scan Velocity: 1000mm/s, and
Scan Separation: 100um

Comparative Example - CdTe layer with no exposure to laser beam: The comparative Example was not treated and was tested as deposited.

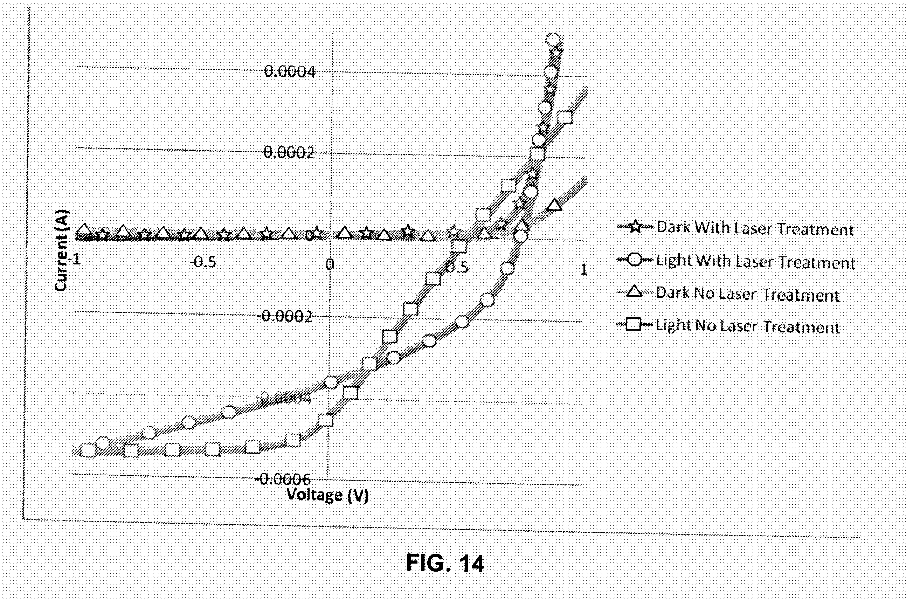

Each of the photovoltaic devices formed in Example 1 and the Comparative Example were manually isolated from this material stack, upon one of which had a laser beam directed at the CdTe layer. A current density voltage plot was obtained for each device in light and dark (i.e., absence of light) conditions as is shown in FIG. 14. As shown in the current density voltage plot in FIG. 14, the resistance was compared by comparing the slope of the current density in the dark condition curve in forward bias corresponding to > 0.75V to 1V for FIG. 14. The slope of the laser treated material (i.e., Example 1) shows a resistance of about 3.9 Ohms, whereas the slope of the sample without laser treatment (i.e., the Comparative Example) gives a resistance of about 37 Ohms.

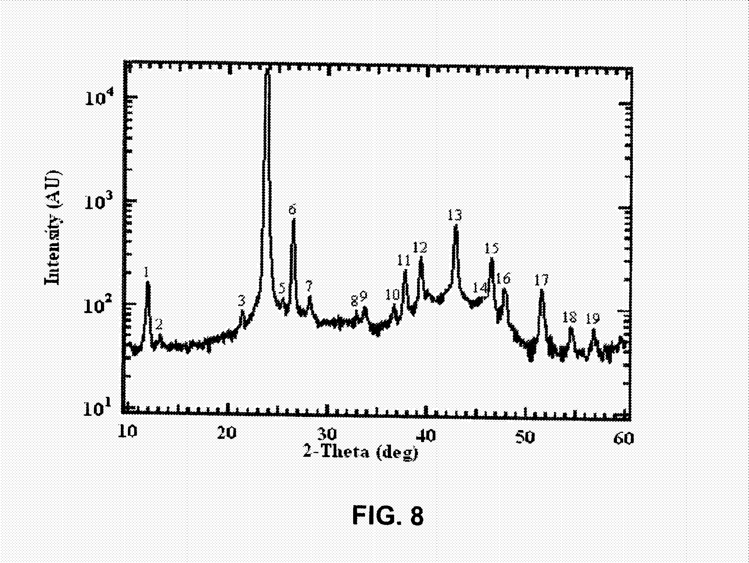

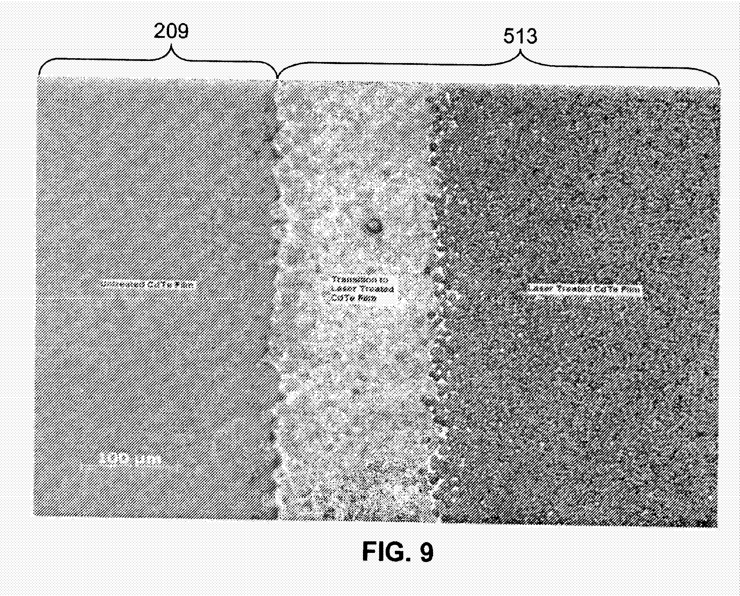

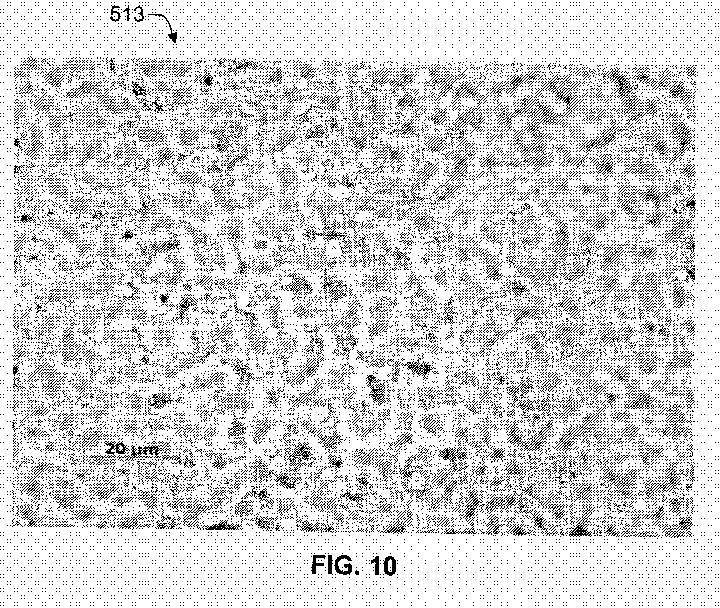

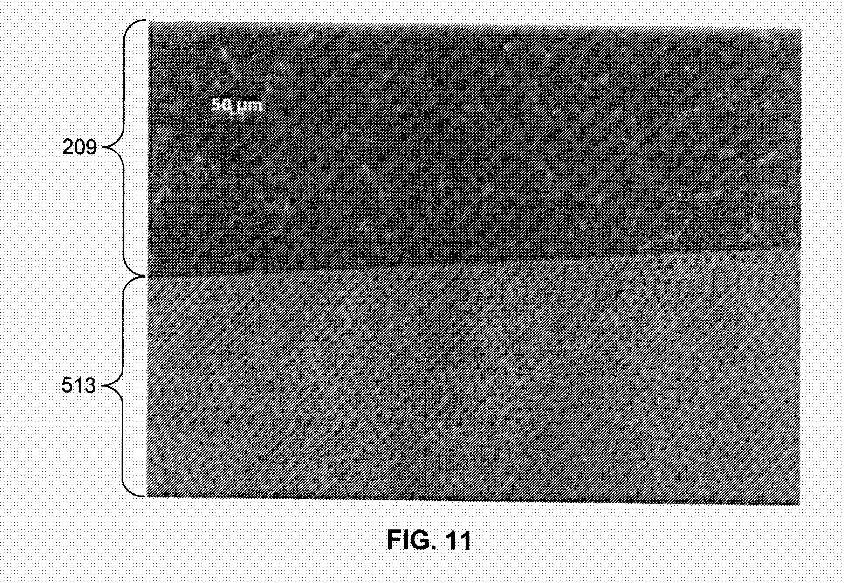

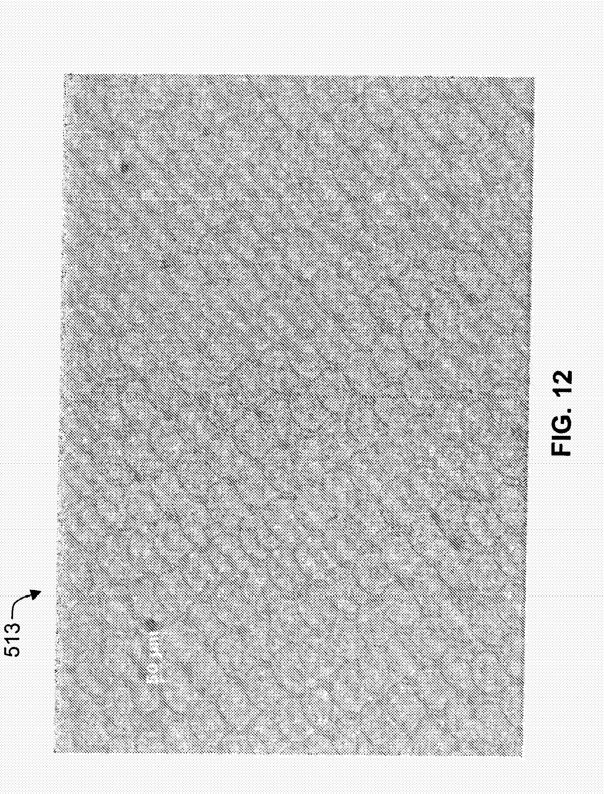

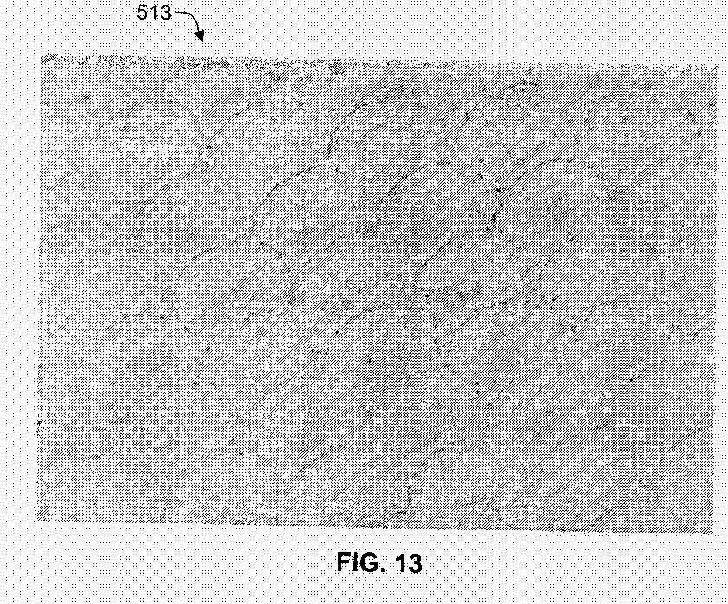

The film exposed to the concentrated electromagnetic energy of the laser beam included a concentration of tellurium that is greater than the concentration in the untreated layer of the Comparative Example. The increased concentration is believed to be due to an increased rate of vaporization of cadmium over that of tellurium. FIG. 8 shows an X-ray Diffraction Pattern for Example 1, which was exposed to the laser beam. FIGs. 9-13 show photomicrographs of modified areas of the CdTe layer of Example 1. FIG. 9 shows modified area 513 and the second semiconductor layer 209 comprising CdTe. FIG. 10 shows an enlarged view of modified area 513 of FIG. 9. FIG. 11 shows modified area 513 and the second semiconductor layer 209 comprising CdTe. FIG. 12 shows an enlarged view of modified area 513 of FIG. 11. FIG. 13 shows a further enlarged view of modified area 513 of FIG. 12. The samples shown in FIGs. 11-13 were obtained using a scan velocity that is greater than the samples shown in FIGs. 9-10. The scan velocity of the samples in FIGs. 11-13 includes a velocity corresponding to a single pulse hit at each position.

While the above has been described with respect to photovoltaic modules and photovoltaic devices, the method, thin film structure and apparatus of the present disclosure are usable with other thin film devices. Other thin film devices usable with the present disclosure include, but are not limited to photo detectors, diode application, or other applications that utilize structures having multiple material components having dissimilar different melting/vaporization points.

While the invention has been described with reference to a preferred embodiment, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims.

## Claims

1. A layer comprising modified cadmium telluride and unmodified cadmium telluride, the layer comprising:
a modified area having a concentration of telluride that is greater than the concentration of telluride in an unmodified cadmium telluride area, the modified area comprising a hexagonal close packed crystal structure.

2. The layer of claim 1, wherein the modified area has a contact resistance that is less than the contact resistance of the unmodified cadmium telluride area.

3. The layer of claim 1 or claim 2, wherein the layer further comprises one or more elements selected from the group consisting of Cu-, Cl-, N-, As-, Sb-, Ag-, Au-, or P- and combinations thereof.

4. The layer of any preceding claim, wherein the modified area includes an X-ray diffraction pattern substantially the same as that shown in FIG. 8.

5. The layer of any preceding claim, wherein the layer forms a semiconductor layer of a photovoltaic module.

6. The layer of any one of claims 1 to 4, wherein the layer forms a semiconductor layer of a gamma ray detector.

7. A method of modifying a layer comprising cadmium telluride, the method comprising:
providing the layer comprising cadmium telluride;
directing concentrated electromagnetic energy to at least a portion of the layer to selectively remove cadmium from the cadmium telluride layer to
form a modified area having a concentration of telluride that is greater than the concentration of telluride in an unmodified cadmium telluride area; and
modifying the layer to produce a hexagonal close packed crystal structure.

8. The method of claim 7, further comprising applying a conductive layer in contact with the modified area.

9. The method of claim 7 or claim 8, wherein the conductive layer includes a material selected from the group consisting of graphite, metallic silver, nickel, copper, aluminum, titanium, palladium, chrome, molybdenum alloys of metallic silver, nickel, copper, aluminum, titanium, palladium, chrome, and molybdenum and combinations thereof.

10. The method of claim 9, wherein the material includes graphite and nickel and aluminum alloys.

11. The method of any one of claims 7 to 10, wherein the concentrated electromagnetic energy is selected from the group consisting of laser, radio frequency, electron beam, infrared, and rapid thermal anneal.

12. A thin film device having a cadmium telluride layer, the device comprising:
a modified area and an unmodified cadmium telluride are disposed within the cadmium telluride layer, the modified area having a concentration of telluride that is greater than the concentration of telluride in the unmodified cadmium telluride area, the modified area comprising a hexagonal close packed crystal structure and the layer is disposed within the device.

13. The thin film device of claim 12, wherein the modified area has a contact resistance that is less than the contact resistance of the unmodified cadmium telluride area.

14. The thin film device of claim 12 or claim 13, further comprising a conductive layer in contact with the modified area.

15. The thin film device of claim 14, wherein the conductive layer includes a material selected from the group consisting of graphite, metallic silver, nickel, copper, aluminum, titanium, palladium, chrome, molybdenum alloys of metallic silver, nickel, copper, aluminum, titanium, palladium, chrome, and molybdenum and combinations thereof.
